(19) Europäisches Patentamt

European Patent Office

Office européen des brevets

(11) **EP 0 781 463 B1**

(12) **FASCICULE DE BREVET EUROPEEN**

(45) Date de publication et mention
de la délivrance du brevet:
**09.10.2002 Bulletin 2002/41**

(51) Int Cl.⁷: **H01S 5/02**, H01S 5/40

(21) Numéro de dépôt: **96924942.4**

(86) Numéro de dépôt international:
**PCT/FR96/01052**

(22) Date de dépôt: **05.07.1996**

(87) Numéro de publication internationale:
**WO 97/003487 (30.01.1997 Gazette 1997/06)**

(54) **SOURCE LASER A SEMICONDUCTEURS**

HALBLEITERLASERQUELLE

SEMICONDUCTOR LASER SOURCE

(84) Etats contractants désignés:
**DE GB**

(30) Priorité: **13.07.1995 FR 9508507**

(43) Date de publication de la demande:
**02.07.1997 Bulletin 1997/27**

(73) Titulaire: **Thales**
**75008 Paris (FR)**

(72) Inventeurs:
• **DUCHEMIN, Jean**
**F-92402 Courbevoie Cédex (FR)**
• **LELIARD, Eugène**
**F-92402 Courbevoie Cédex (FR)**
• **BROUSSE, Eric**
**F-92402 Courbevoie Cédex (FR)**
• **FILLARDET, Thierry**
**F-92402 Courbevoie Cédex (FR)**

(56) Documents cités:
GB-A- 1 096 575     US-A- 3 835 414
US-A- 4 791 634     US-A- 5 016 083

• **PATENT ABSTRACTS OF JAPAN vol. 009, no. 019 (E-292), 25 Janvier 1985 & JP,A,59 165473 (NIPPON DENKI KK), 18 Septembre 1984,**
• **OPTICAL AND QUANTUM ELECTRONICS, vol. 11, no. 4, Juillet 1979, LONDON, GB, pages 319-327, XP002015384 W.NAKWASKI: "The thermal properties of a single-heterostructure laser diode supplied with short current pulses"**
• **IEEE JOURNAL OF QUANTUM ELECTRONICS, vol. 28, no. 4, 1 Avril 1992, pages 952-965, XP000272686 ENDRIZ J G ET AL: "High power diode laser arrays" cité dans la demande**

## Description

L'invention concerne une source laser à semiconducteurs et notamment une structure de modules élémentaires assemblés par pincement mécanique.

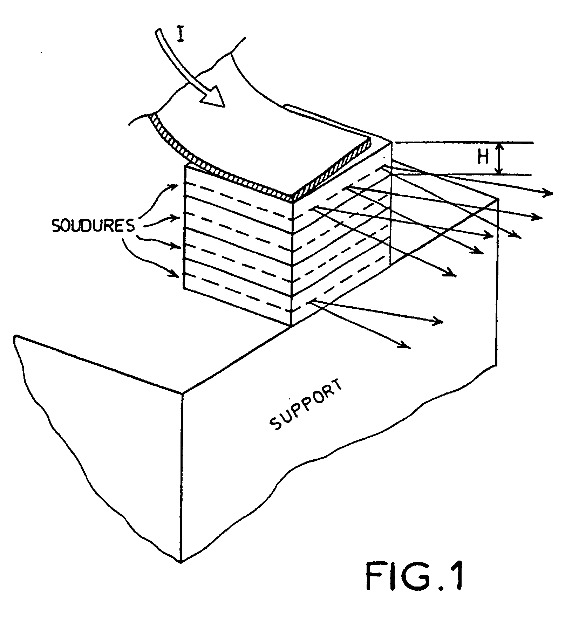

Dès les années 70, il a été proposé d'exploiter les propriétés avantageuses des diodes laser (commodité de modulation rapide directe, rendement élevé de conversion d'énergie électrique en énergie lumineuse dans une bande spectrale étroite ...) pour réaliser des dispositifs capables de générer des densités élevées de puissance par unité de surface. A cet effet des diodes laser élémentaires monolithiques étaient assemblées par soudure sous forme d'empilements tels que schématisés dans la figure 1 au cas de quatre diodes élémentaires. On conçoit que la densité de puissance émise est, toutes choses égales par ailleurs, inversement proportionnelle à la hauteur H de la diode élémentaire.

De tels dispositifs ont été commercialisés dans les années 70 par la société Laser Diode Laboratories avec de nombreuses variantes différant par le nombre d'éléments empilés et le nombre d'empilements assemblés. Les diodes laser élémentaires étaient des diodes à hétérojonction unique qui avaient une densité de courant de seuil de l'ordre de $10^4$ A/cm$^2$, ce qui imposait un fonctionnement en impulsions courtes (typiquement 100 ns) avec des fréquences de récurrence faible (typiquement 1 kHz). De tels assemblages pouvaient fournir des puissances crêtes de plusieurs kW ; une application visée parmi d'autres était l'éclairage pulsé de scènes dans l'infrarouge proche.

La mise au point des diodes laser à puits quantique dans les années 80 a permis d'améliorer considérablement leurs propriétés, courant de seuil et rendement différentiel, et par suite d'augmenter le rendement de conversion d'énergie qui peut atteindre 50 % en impulsions longues (plusieurs centaines de μs) ou en continu.

Ces nouvelles caractéristiques ont stimulé l'application des diodes laser au pompage des lasers à solide, en particulier le YAG:Néodyme, en remplacement des flashes ou des lampes avec une augmentation du rendement "à la prise" de ces lasers d'un facteur supérieur à 10. Cette augmentation est due essentiellement à la faible largeur spectrale (3 nm) des diodes laser, comparée à celle des sources "blanches". Le régime typique de fonctionnement, dit "quasi continu" ou QCW, consiste en impulsions "longues" (quelques 100 μs) et il est également intéressant d'augmenter la fréquence de récurrence au-delà des 100 Hz obtenus avec les flashes. Des produits sont commercialisés, par exemple par la société Spectra Laser Diodes, sous forme d'empilements hybrides tels que décrits dans le document J.G. Endriz et al., High power diode laser arrays, IEEE J. Quantum Electron., 28(4), 952-965, April 1992, dont la conception a pour objet évident de permettre un fonctionnement à cadence et par suite à puissance moyenne élevées. Dans ce but, les diodes monolithiques en barrettes de largeur 1cm typiquement, sont soudées sur des supports en matériau bon conducteur de la chaleur, sous forme de modules élémentaires qui sont eux-mêmes assemblés par soudure sur un support commun en nombre dépendant de la puissance à obtenir et connectés électriquement en série.

Ce type d'assemblage a deux inconvénients :

- le coût de l'assemblage est élevé ;
- la densité de puissance émise est limitée géométriquement par la hauteur d'un module élémentaire.

Le document US 3 835 414 décrit un empilement de diodes lasers prévoyant des plaques support de contact entre les différentes diodes lasers. L'invention a pour objet de simplifier une telle structure.

L'invention a donc d'abord pour but de remédier à l'inconvénient du coût pour certaines applications, de pompage de lasers à solide, qui nécessiteront des quantités importantes d'empilements et par suite ne seront économiquement viables qu'avec une diminution sensible des coûts de fabrication, mais ne demanderont pas des fonctionnements pulsés dont le taux de récurrence soit élevé. L'invention a de plus l'avantage de permettre un accroissement de la densité de puissance émise.

Le coût peut être analysé en deux composantes.

1. Le "front end", ensemble des technologies collectives (épitaxie des matériaux, microlithograhie, métallisation des contacts électriques), a un coût ramené au dispositif élémentaire qui décroît très vite avec les quantités produites comme le montre toute l'histoire du silicium. Ce sera inéluctablement le cas pour les barrettes de diodes laser.

2. Le coût du "back end", ensemble des technologies d'assemblage et d'encapsulation, devient donc prépondérant d'autant plus que les fonctions réalisées sont complexes. C'est le cas pour les empilements commercialisés aujourd'hui.

L'invention vise donc à réduire le coût de l'assemblage par une simplification et une optimisation des modules élémentaires et une simplification de leur assemblage. Elle présente l'avantage de réduire la hauteur H du module élémentaire, et par suite, de permettre un accroissement de la densité de puissance crête émise en régime pulsé.

L'invention concerne donc une source laser à semiconducteurs comportant un empilement de diodes lasers à semiconducteurs comportant chacune au moins une région active constituée d'une série de couches à semiconducteurs situées entre une couche de contact ohmique et un substrat tenant lieu également de couche de contact ohmique, caractérisée en ce qu'elle comporte des moyens de pression maintenant les diodes en contact les unes avec les autres par leurs couches de contacts ohmiques.

Les différents objets et caractéristiques de l'invention apparaîtront plus clairement dans la description qui va suivre et dans les figures annexées qui représentent :

- la figure 1, un empilement de diodes lasers selon l'art connu ;
- la figure 2, un module simple d'une diode laser ;
- la figure 3, un module de diode laser auquel est associé une lame de dissipation thermique comme cela est connu dans la technique ;
- la figure 4, un exemple de réalisation simplifié d'un empilement de diodes laser selon l'invention ;
- la figure 5, des courbes de variations en fonction du temps, du courant injecté dans une diode laser et de la variation de température de la région active de la diode ;
- la figure 6, des courbes de variation, en fonction du courant injecté, de la puissance crête de la diode et de la température embase bas ;
- la figure 7, des courbes en fonction du courant injecté, de la longueur d'onde de la lumière émise par la diode et de la largeur spectrale ;
- la figure 8, un profil de température moyenne en régime établi dans un empilement de diode laser selon l'invention ;
- la figure 9, une évolution de la température dans un module hybride de diode laser pendant une impulsion de durée $\tau$ ;
- la figure 10, un exemple de réalisation d'un montage pour empilement de diodes laser selon l'invention ;
- la figure 11, une variation de réalisation selon l'invention.

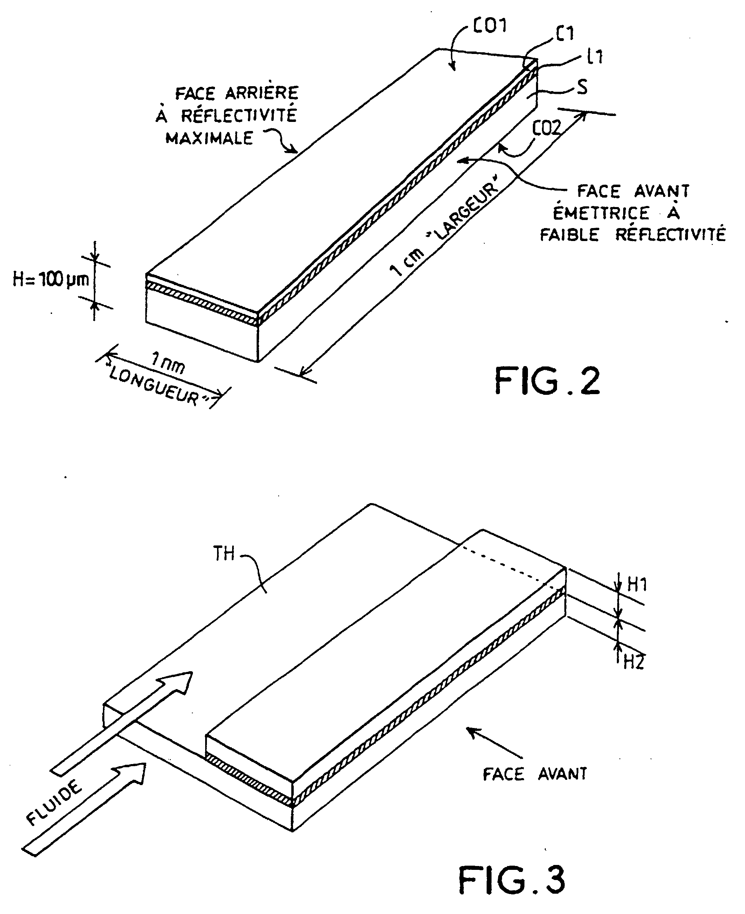

En se reportant aux figures 2 à 4, on va donc décrire la constitution d'un exemple de réalisation d'un empilement de diodes lasers selon l'invention.

Les diodes lasers élémentaires utilisées dans le cadre de l'invention sont des modules simplifiés par rapport à ceux utilisés dans la technique.

Selon la figure 2, une diode laser comporte simplement une barrette de semiconducteur monolithique dimensionnée comme cela sera décrit ultérieurement. On désignera cette structure comme "module simple". Une telle barrette comporte sur un substrat S de matériau semiconducteur, une région active l1 constituée d'une série de couches revêtue d'une couche de contact ohmique c1. Le substrat S peut jouer également le rôle de couche de contact ohmique.

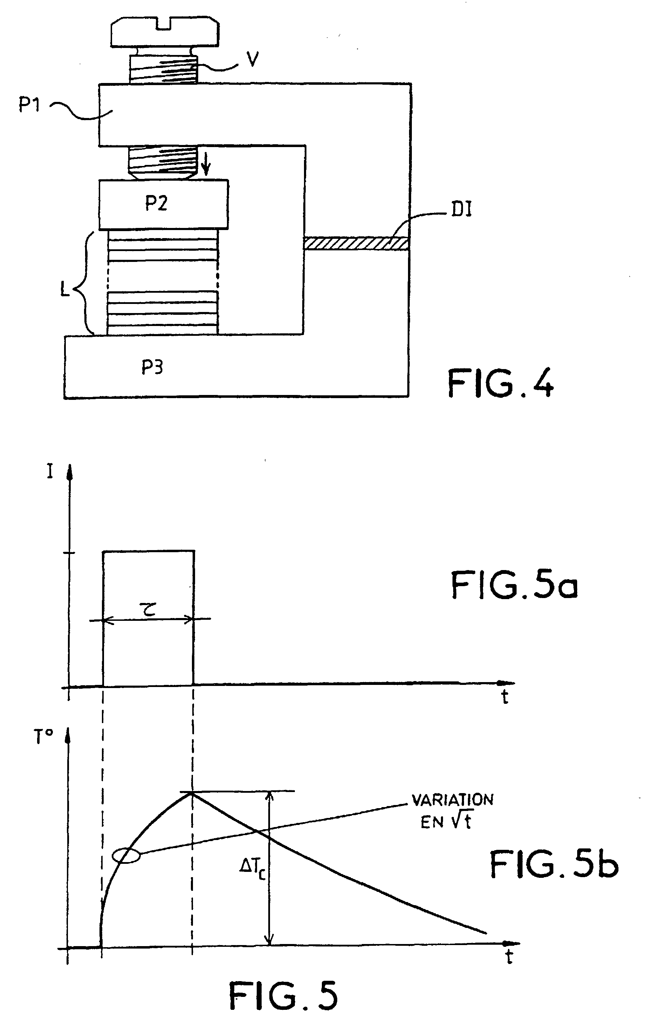

Selon l'invention, un certain nombre de modules tels que ceux de la figure 2 empilés pour constituer une source laser L comme représenté en figure 4. Ils sont maintenus par pincement entre deux pièces conductrices P2 et P3. La pièce P2 est pressée contre le laser L par la vis V qui prend appui sur la pièce P1. Les pièces P1 et P3 et donc les pièces P2 et P3 sont isolées l'une de l'autre électriquement par un isolant DI.

Les pièces P2 et P3 permettent donc l'amenée du courant d'excitation à l'empilement L de diodes lasers.

De nombreuses variantes peuvent être envisagées pour ce qui concerne les moyens de réaliser le pincement de l'empilement L.

Les couches d'or prévues précédemment sur les faces principales des modules permettent un meilleur contact entre les modules. Ceux-ci ne sont donc pas soudés entre eux.

Au montage, les pièces P2 et P3 sont écartées et les modules élémentaires préalablement testés sont introduits successivement -en position, puis les mâchoires sont serrées et les modules sont à la fois maintenus mécaniquement et connectés électriquement de façon à être alimentés en série. Ce dispositif présente l'avantage de pouvoir être démonté pour un éventuel échange de module. La géométrie des mâchoires peut être conçue de façon à assurer un positionnement parallèle des modules par appui de leur face arrière sur des butées adéquates.

Les applications de pompage de lasers à solide nécessitent que le régime de fonctionnement choisi n'entraîne pas un élargissement spectral supérieur à la largeur de la bande d'absorption utile de l'ion utilisé, par exemple 3 nm pour l'ion Néodyme dans le YAG. Or la longueur d'onde émise par une diode laser varie avec la température de sa région active avec un coefficient dont l'ordre de grandeur est

$$d\lambda/dT = 0,3 \text{ nm}/^{\circ}C$$

pour la longueur d'onde de 808 nm utilisée pour l'ion Néodyme. La figure 5 représente schématiquement les variations du courant injecté (5a) et de la température de région active (5b) pour une excitation en régime puisé : il résulte de ce qui précède que l'excursion de température $\Delta T_m$ ne doit pas dépasser 10°C dans l'exemple choisi. Les dispositifs selon l'invention sont optimisés dans ce but.

On suppose qu'une barrette active est constituée d'un substrat (par exemple GaAs) sur lequel est déposé un ensemble de couches épitaxiales qui en constitue la région active et est optimisée. Les paramètres à déterminer sont l'épaisseur du substrat d'une barrette active, la nature et l'épaisseur du dissipateur thermique dans le cas d'un empilement hybride ainsi que le nombre de modules.

On va maintenant déterminer les paramètres caractérisant la structure selon l'invention de façon à satisfaire des températures d'échauffement moyennes et transitoire maximales.

On considère un empilement de modules qui peuvent être

- soit des modules simples constitués chacun par une barrette monolithique de diodes laser ;

- soit des modules hybrides composés d'une barrette de diodes laser associée à une barrette radiateur en matériau conducteur de la chaleur (silicium, carbure de silicium, cuivre-tungstène, etc).

Une cale en matériau convenable peut être intercalée entre la face supérieure de l'empilement pour symétriser l'ensemble.

Les faces extérieures des modules extrêmes sont supposées maintenues à une température constante de référence.

Régime d'excitation

On s'intéresse à un régime pulsé à faible taux de remplissage :

- courant injecté de l'ordre de 120 A fournissant une puissance optique de 100 W par barrette, valeur maximale ne dégradant pas le dispositif ;
- tension aux bornes de la région active de chaque barrette 2 V ;
- durée d'impulsion voisine de 100 μs ;
- fréquence de récurrence inférieure à 100 Hz de sorte qu'entre deux impulsions successives la température ait le temps de s'homogénéiser dans la structure.

Température moyenne

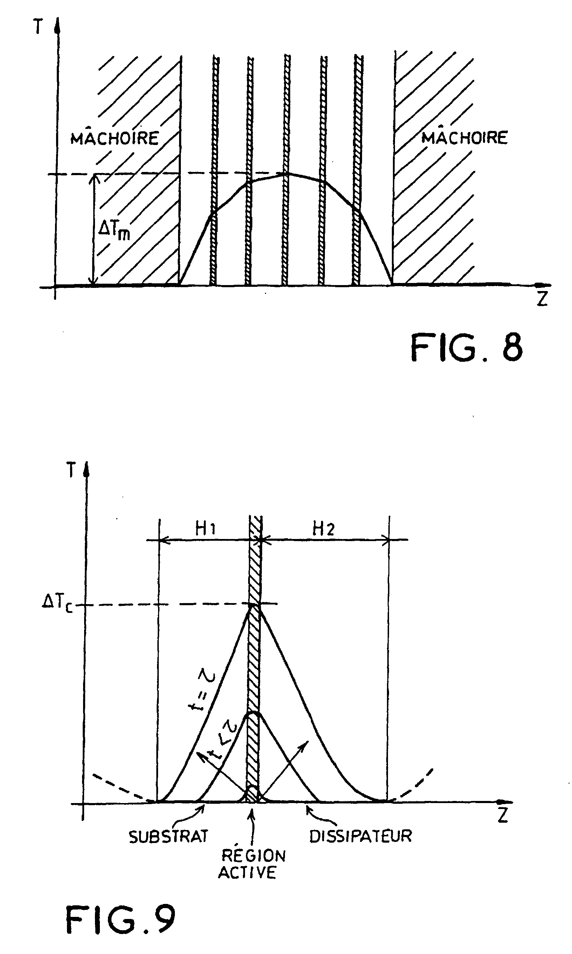

Le profil de température moyenne en régime établi, selon un axe perpendiculaire au plan des modules, est schématisé sur la figure 8. On peut donner une expression approchée de $\Delta T_m$, valeur maximale de cet échauffement obtenue au centre de la structure, pour un empilement hybride. Cette expression est valable dès que le nombre de modules dépasse quelques unités :

$$\Delta T_m = F\tau f(H_1/K_1 + H_2/K_2)N(N+2)/8 \qquad (1)$$

- F : flux de chaleur crête généré dans la région active de chaque barrette, par exemple 2kW/cm², correspondant à des impulsions de puissance crête électrique de 300 W en supposant un rendement de conversion d'énergie de 33 % et une surface de barrette de 0,1 cm².
- $\tau$ : durée des impulsions, par exemple 100 μs.
- f : fréquence de répétition des impulsions, par exemple 10 Hz.
- $H_1$ et $H_2$ : épaisseurs respectives d'une barrette et du dissipateur associé. Ces épaisseurs sont égales à la demi-épaisseur du substrat pour un empilement simple, par exemple 100 μm.
- $K_1$ et $K_2$ : conductivités thermiques respectives des

matériaux considérés. $K_1$ = 0,46 W/cm/°C pour GaAs et $K_2$ = 4,5 W/cm/°C pour SiC.
- N : nombre de modules élémentaires, N = 10 par exemple.

Avec ces données et dans le cas d'un empilement simple, on obtient $\Delta T_m$ = 1,3°C, négligeable par rapport à l'amplitude du transitoire thermique considéré ensuite.

Température transitoire

Pendant la durée d'une impulsion d'excitation, s'ajoute au profil moyen précédent un profil transitoire qui évolue au cours du temps comme il est montré sur la figure 9 qui représente une période de la structure périodique constituée par l'empilement. Dans la mesure où les épaisseurs des matériaux sont supérieures aux longueurs de diffusions de la chaleur :

$$\text{épaisseur} \geq \sqrt{\tau\frac{K}{\rho c}} \qquad (2)$$

(50 μm pour $\tau$ = 100 μs dans GaAs), les matériaux où s'écoule la chaleur peuvent être considérés comme infinis et l'élévation de température de la région active $\Delta T_C$ à la fin d'une impulsion de durée $\tau$ est donnée par :

$$\Delta T_C = 2F\sqrt{(\tau/\pi)}/(\sqrt{(K_1\rho_1 C_1)} + \sqrt{(K_2\rho_2 C_2)}) \qquad (3)$$

K, $\rho$ et C sont respectivement les conductivité thermique, masse volumique et chaleur massique des deux matériaux situés de part et d'autre de la région active. Au cas de l'empilement simple les matériaux 1 et 2 sont GaAs.

Dans les conditions d'excitation déjà définies on obtient les résultats suivants :

- empilement simple : $\Delta T_C$ = 12°C, ce qui est une valeur maximale à ne pas dépasser ;
- empilement hybride avec barrette radiateur en SiC : $\Delta T_C$ = 5°C.

Les formules données précédemment permettent d'optimiser la conception d'un empilement (épaisseurs, nombre de barrettes, etc) -en fonction de telle application particulière, par exemple de la puissance émise et du régime d'excitation souhaités.

Par exemple, on se fixe une valeur de température transitoire $\Delta T_C$ maximale. A l'aide de la formule (3) on détermine un couple de valeurs F (flux de chaleur dans la région active) et $\tau$ (durée d'une impulsion). Choisissant par exemple une valeur F, on détermine une durée d'impulsion $\tau$. Ensuite à l'aide de la formule (2) on détermine les épaisseurs minimales des matériaux en-

cadrant la région active.

$\Delta T_C$ est l'échauffement crête minimal qu'il est possible d'obtenir. Une diminution des épaisseurs du substrat et du dissipateur en deçà de la longueur de diffusion de la chaleur pour la durée d'impulsion souhaitée augmenterait $\Delta T_C$, une augmentation de ces épaisseurs ne diminuerait pas $\Delta T_C$ mais diminuerait la densité de puissance émise.

A titre d'exemple, on considère un empilement de 10 barrettes élémentaires (modules simples) conçues selon les règles de l'art et dont les dimensions de chaque barrette sont les suivantes :

- épaisseur du substrat GaAs : 100 μm
- largeur : 1 cm
- longueur (dans la direction de l'émission laser) : 1 mm
- puissance optique émise : 100 W pour un courant de 120 A sous 2 V

En régime pulsé (100 μs, 10 Hz) l'échauffement moyen est négligeable et l'échauffement crête est de 12°C ce qui est acceptable pour de nombreuses applications. La puissance émise est de 1 kW pour une surface effective de 0,1 cm$^2$.

Si on considère des structures où l'évacuation de la chaleur a lieu uniquement par les pièces maintenant les modules par pincement et par les côtés des modules, la fréquence de récurrence des impulsions doit être limitée par exemple vers 100 Hz pour des impulsions de 100 μs et un empilement de 10 modules simples.

On a considéré des structures où l'évacuation de la chaleur a lieu uniquement par les pièces maintenant les modules par pincement. Ceci limite la fréquence de récurrence des impulsions vers 100 Hz pour des impulsions de 100 μs et un empilement de 10 modules simples.

On peut concevoir également, comme cela est connu dans la technique, des modules hybrides où un dissipateur a une longueur supérieure à celle de la barrette monolithique et dont la partie arrière dépasse de l'empilement et joue le rôle d'ailette refroidie par une circulation et/ou vaporisation de fluide (figure 3). Ce type de structure ne diminue pas sensiblement l'échauffement transitoire qui est limité par le transport de chaleur perpendiculairement au plan des modules, mais il permet d'améliorer le refroidissement moyen. On peut ainsi choisir :

- soit d'augmenter la fréquence de récurrence ;
- soit d'augmenter le nombre de modules de l'empilement, par rapport aux valeurs de l'exemple choisi.

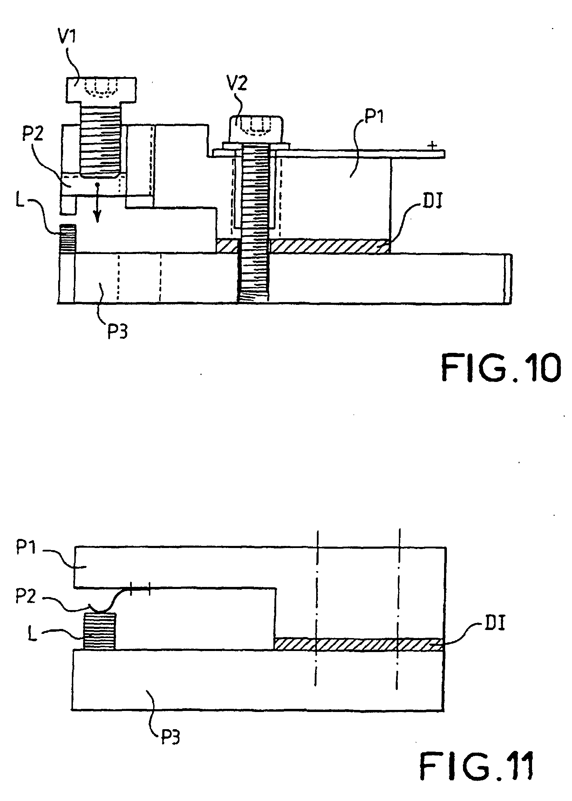

Un dispositif permettant le pincement d'un empilement a été réalisé tel que représenté en figure 10.

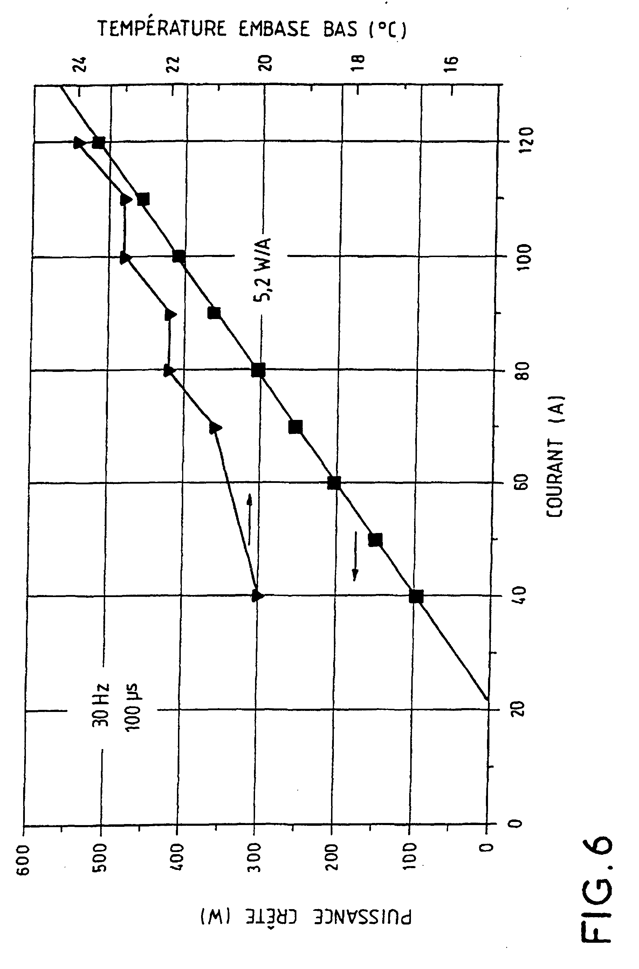

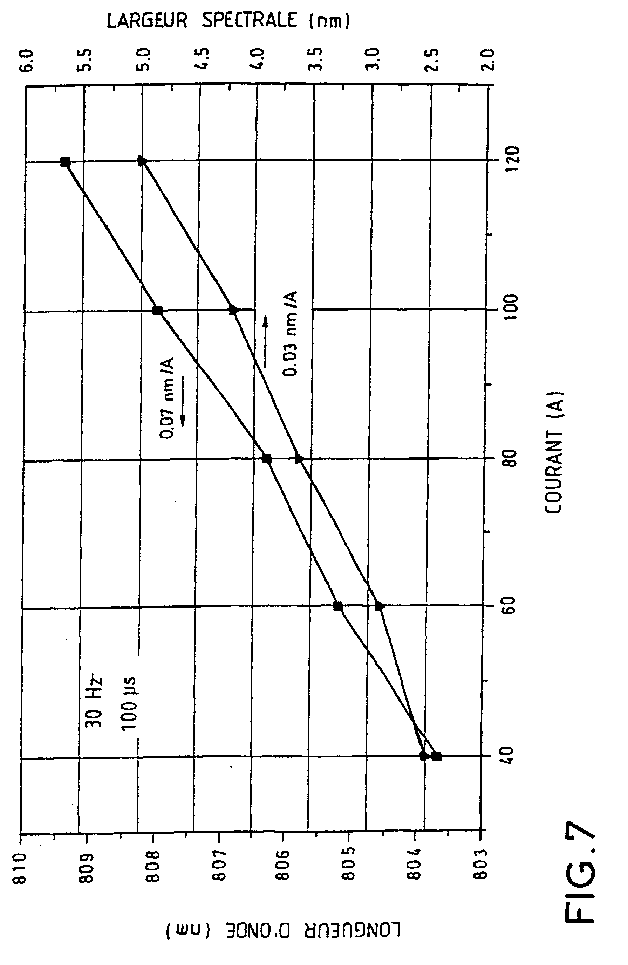

Les caractéristiques d'un empilement de 5 barrettes sont données sur les figures 6 et 7 montrant respectivement pour un régime pulsé à 100 μs et 30 Hz :

- la caractéristique P/I (puissance émise fonction du courant injecté)
- l'évolution de la largeur spectrale en fonction du courant injecté.

Ces courbes vérifient bien les ordres de grandeur évalués plus haut.

Il comporte un socle P3 sur lequel est posé un empilement L de diode laser. Une pièce de serrage P2 coulisse sur une pièce fixe P1 et permet à l'aide d'une vis de serrer l'empilement L. La pièce fixe P1 est fixé au socle P3 par une vis V2 et est isolée du socle P3 par une plaque isolante DI.

La figure 11 représente une variante de réalisation simplifiée dans laquelle la pièce de serrage P2 est un ressort qui est fixé à la pièce fixe P1 et qui comprime l'empilement de diode L contre le socle P3. La pièce fixe P1 est fixée au socle P3 par une lame isolante DI.

## Revendications

1. Source laser à semiconducteurs comportant un empilement de diodes lasers à semiconducteurs comportant chacune au moins une région active (I1) constituée d'une série de couches à semiconducteurs situées entre une couche de contact ohmique (C) et un substrat (S) tenant lieu également de couche de contact ohmique, **caractérisée en ce qu'**elle comporte des moyens de pression maintenant les diodes en contact les unes avec les autres par leurs couches de contacts ohmiques.

2. Source laser selon la revendication 1, **caractérisée en ce que** pour une valeur maximale $\Delta T_m$ d'échauffement au centre de l'empilement de diodes laser, le nombre N de diodes empilées est donné par la formule :

$$\Delta T_m = F\tau f(H_1 K_1 + H_2 K_2)N(N+2)/8$$

avec:

- F : flux de chaleur crête généré dans la région active de chaque diode ;
- $\tau$ : durée des impulsions ;
- f : fréquence de répétition des impulsions ;
- $H_1$, $H_2$ : les épaisseurs respectives d'une diode et d'une lame de dissipation thermique ;
- $K_1$, $K_2$ : les conductivités thermiques respectives des matériaux de la diode et de la lame de dissipation thermique ;
- N : nombre de diodes empilées.

**3.** Source laser selon l'une des revendications 1 ou 2, **caractérisée en ce que** les épaisseurs des matériaux situés de part et d'autre de la région active de chaque diode (substrat et éventuellement lame de dissipation thermique) sont supérieures ou égales à la longueur de diffusion de la chaleur dans chaque matériau.

**4.** Source laser selon la revendication 3, **caractérisée en ce que** l'épaisseur de chaque matériau est supérieure ou égale à

$$\sqrt{\frac{\tau K}{\rho C}},$$

- $\tau$ étant la durée d'une impulsion ;
- K, $\rho$ et C étant respectivement les conductivités thermiques, masse volumique et chaleur massique des matériaux.

**5.** Source laser selon l'une quelconque des revendications précédentes, **caractérisée en ce que** pour une valeur d'élévation de la température $\Delta T_C$ d'une région active à la fin d'une impulsion, on détermine la valeur d'un couple de paramètres F.$\tau$ à l'aide de la formule :

$$\Delta T_C = 2F\sqrt{(\tau/\pi)}/(\sqrt{K_1\rho_1 C_1}+\sqrt{K_2\rho_2 C_2})$$

dans laquelle :

F : flux de chaleur crête généré dans région active de chaque diode
$\tau$ : durée des impulsions
$K_1$ et $K_2$, $\rho_1$ et $\rho_2$, $C_1$ et $C_2$ : respectivement les conductivités thermiques, masses volumiques et chaleurs massiques des matériaux encadrant une région active ;

ensuite à partir de la valeur d'un paramètre F ou $\tau$, on détermine la valeur de l'autre paramètre ; la valeur de $\tau$ permettant de déterminer les épaisseurs des matériaux encadrant la région active d'une diode.

**6.** Source laser selon la revendication 1, **caractérisée en ce que** la couche active laser (l1) est à base de GaAs.

**7.** Source laser selon la revendication 1, **caractérisée en ce que** les moyens de pression comprennent deux pièces de pression (P2, P3) isolées électriquement l'une de l'autre et couplées mécaniquement, l'une d'elle étant mobile par rapport à l'autre.

**8.** Source laser selon la revendication 1, **caractérisée**

**en ce que** les contacts ohmiques (C01, C02) sont rechargés en or électrolytique.

**9.** Source laser selon la revendication 1, **caractérisée en ce que** l'empilement de diodes lasers ne comporte ni de soudure, ni de brasure.

**10.** Source laser selon l'une des revendications 1 ou 2, **caractérisée en ce que** les épaisseurs des matériaux situés de part et d'autre de la région active de chaque diode sont inférieures à la longueur de diffusion de la chaleur dans chaque matériau.

**Patentansprüche**

**1.** Halbleiter-Laserquelle mit einem Stapel von Halbleiter-Laserdioden, die je mindestens eine aktive Zone ($\ell$1) in Form einer Serie von Halbleiterschichten zwischen einer ohm'schen Kontaktschicht (C1) und einem Substrat (S) enthält, das auch als ohm'sche Kontaktschicht wirkt, **dadurch gekennzeichnet, daß** sie Spannmittel aufweist, die die Dioden über ihre ohm'schen Kontaktschichten in Kontakt miteinander halten.

**2.** Laserquelle nach Anspruch 1, **dadurch gekennzeichnet, daß** für einen Höchstwert $\Delta T_m$ der Erwärmung im Zentrum des Laserdiodenstapels die Anzahl N von gestapelten Dioden sich aus folgender Formel ergibt:

$$\Delta T_m = F \cdot \tau \cdot f \cdot (H_1/K_1 + H_2/K_2) \cdot N \cdot (N+2)/8$$

wobei gilt:

- F ist der Spitzenwert des in der aktiven Zone jeder Leiste erzeugten Wärmeflusses,
- $\tau$ ist die Dauer de Impulse,
- f ist die Wiederholfrequenz der Impulse,
- $H_1$ und $H_2$ bezeichnen die Dicke einer Diode beziehungsweise die Dicke eines Wärmeabfuhrplättchens,
- $K_1$ und $K_2$ sind die Wärmeleitwerte der Materialien der Diode beziehungsweise des Wärmeabfuhrplättchens,
- N ist die Anzahl der gestapelten Dioden.

**3.** Laserquelle nach einem der Ansprüche 1 und 2, **dadurch gekennzeichnet, daß** die Dicke der Materialien zu beiden Seiten der aktiven Zone jeder Diode (Substrat und gegebenenfalls Wärmeabfuhrplättchen) größer/gleich der Diffusionsstrecke der Wärme in jedem Material ist.

**4.** Laserquelle nach Anspruch 3, **dadurch gekennzeichnet, daß** die Dicke jedes Materials größer/

gleich $\sqrt{\tau} \cdot K / \rho \cdot C$ ist, wobei $\tau$ die Dauer eines Impulses ist, während K, $\rho$ und C der Wärmeleitwert, die Volumenmasse und die Massenwärme der Materialien sind.

5. Laserquelle nach einem beliebigen der vorstehenden Ansprüchen, **dadurch gekennzeichnet, daß** für einen Wert der Temperaturerhöhung $\Delta T_c$ einer aktiven Zone am Ende eines Impulses der Wert eines Parameterpaars (F, $\tau$) mithilfe der folgenden Formel bestimmt wird:

$$\Delta T_c = 2 \cdot F \sqrt{(\tau/\pi)} / (\sqrt{K_1 \cdot \rho_1 \cdot C_1} + \sqrt{K_2 \cdot \rho_2 \cdot C_2}),$$

wobei gilt:

- F ist der Spitzenwert des in der aktiven Zone jeder Diode erzeugten Wärmeflusses,
- $\tau$ ist die Dauer der Impulse,
- $K_1$ und $K_2$, $\rho_1$ und $\rho_2$, $C_1$ und $C_2$ sind die Wärmeleitwerte beziehungsweise die Volumenmassen und Massenwärmen der Materialien, die eine aktive Zone umgeben,

und daß dann ausgehend vom Wert eines der Parameter F und $\tau$ der Wert des anderen bestimmt wird, wobei der Wert von $\tau$ die Bestimmung der Dikke der Materialien um die aktive Zone einer Diode herum festlegt.

6. Laserquelle nach Anspruch 1, **dadurch gekennzeichnet, daß** die aktive Laserschicht ($\ell$1) auf GaAs beruht.

7. Laserquelle nach Anspruch 1, **dadurch gekennzeichnet, daß** die Spannmittel zwei Spannglieder (P2, P3) enthalten, die elektrisch gegeneinander isoliert, aber mechanisch miteinander gekoppelt sind, wobei eines bezüglich des anderen beweglich ist.

8. Laserquelle nach Anspruch 1, **dadurch gekennzeichnet, daß** die ohm'schen Kontakte CO1, CO2) mit einer elektrolytisch aufgebrachten Goldschicht versehen sind.

9. Laserquelle nach Anspruch 1, **dadurch gekennzeichnet, daß** der Stapel von Laserdioden weder verschweißt noch verlötet ist.

10. Laserquelle nach einem der Ansprüche 1 und 2, **dadurch gekennzeichnet, daß** die Dicke der Materialien zu beiden Seiten der aktiven Zone größer als die Diffusionsstrecke der Wärme in jedem Material ist.

**Claims**

1. Semiconductor laser source, including a stack of semiconductor laser diodes, each including at least one active region (11) consisting of a series of semiconductor layers located between an ohmic contact layer (c1) and a substrate (S) which also assumes the function of an ohmic contact layer, **characterized in that** it includes pressure means which keep the diodes in contact with one another via their ohmic contact layers.

2. Laser source according to Claim 1, **characterized in that**, for a maximum value $\Delta T_m$ of the heating at the centre of the stack of laser diodes, the number N of stacked diodes is given by the formula:

$$\Delta T_m = F \tau f (H_1 K_1 + H_2 K_2) N(N+2)/8$$

with:

- F: Peak heat flux generated in the active region of each diode;
- $\tau$: Duration of the pulses;
- f: Repetition frequency of the pulses;
- $H_1$, $H_2$: The respective thicknesses of a diode and of a thermal dissipation sheet;
- $K_1$, $K_2$: The respective thermal conductivities of the materials of the diode and of the thermal dissipation sheet;
- N: Number of stacked diodes.

3. Laser source according to one of Claims 1 and 2, **characterized in that** the thicknesses of the materials located on either side of the active region of each diode (substrate and, optionally, thermal dissipation sheet) are greater than or equal to the thermal diffusion length in each material.

4. Laser source according to Claim 3, **characterized in that** the thickness of each material is greater than or equal to

$$\sqrt{\frac{\tau K}{\rho C}};$$

- $\tau$ being the duration of a pulse;
- K, $\rho$ and C being respectively the thermal conductivities, density and specific heat capacity of the materials.

5. Laser source according to any one of the preceding claims, **characterized in that**, for a value of the rise in temperature $\Delta T_C$ of an active region at the end of a pulse, the value of a pair of parameters F.$\tau$ is determined with the aid of the formula:

$$\Delta T_C = 2F\sqrt{(\tau/\pi)}/(\sqrt{(K_1\rho_1 C_1)}+\sqrt{(K_2\rho_2 C_2)})$$

in which:

F: Peak heat flux generated in the active region of each diode

$\tau$: Duration of the pulses

$K_1$ and $K_2$, $\rho_1$ and $\rho_2$, $C_1$ and $C_2$: respectively the thermal conductivities, densities and specific heat capacities of the materials enclosing an active region;

then, on the basis of the value of one parameter F or $\tau$, the value of the other parameter is determined; the value of $\tau$ making it possible to determine the thicknesses of the materials enclosing the active region of a diode.

6. Laser source according to Claim 1, **characterized in that** the active laser layer (11) is based on GaAs.

7. Laser source according to Claim 1, **characterized in that** the pressure means comprise two pressure parts (P2, P3), electrically insulated from one another and mechanically coupled, one of them being mobile relative to the other.

8. Laser source according to Claim 1, **characterized in that** the ohmic contacts (C01, C02) are supplemented with electrolytic gold.

9. Laser source according to Claim 1, **characterized in that** the stack of laser diodes includes no soldering or brazing.

10. Laser source according to one of Claims 1 and 2, **characterized in that** the thicknesses of the materials located on either side of the active region of each diode are less than the thermal diffusion length in each material.

FIG.1

FACE ARRIÈRE
À RÉFLECTIVITÉ
MAXIMALE

CO1

C1

L1

S

CO2

FACE AVANT
ÉMETTRICE À
FAIBLE RÉFLECTIVITÉ

1 cm "LARGEUR"

H = 100 μm

1 nm
"LONGUEUR"

## FIG.2

TH

H1

H2

FLUIDE

FACE AVANT

## FIG.3

FIG.4

FIG.5a

FIG.5b

FIG.5

FIG.6

FIG.7

FIG. 8

FIG.9

FIG.10

FIG.11